# EUROPEAN PATENT APPLICATION

(11) **EP 4 618 699 A2**
(43) Date of publication of application: **17.09.2025**
(21) Application number: 25163352.5
(22) Date of filing: 12.03.2025
(51) Int. Cl.: H05K 3/22, H05K 3/00, H05K 3/12, H05K 3/26

(54) **DUAL LASER REPAIR DEVICE AND OPERATING METHOD THEREOF**

(30) Priority: 12.03.2024 TW 113109025
(71) Applicant: Manz Taiwan Ltd., Taoyuan City 320 (TW)
(72) Inventor: YEN, Chun-Ying, 320 Taoyuan City (TW)
(74) Representative: Lang, Christian

(57) **Abstract**

An operating method of a dual laser repair device (100) is used to repair a circuit board (200) with circuit defects, wherein a defective circuit (210) has two conducting portions (214) and a defective portion (2121) located between the two conducting portions (214). The operating method includes: using a first laser member (112) of a dual laser repair module (110) to emit a laser beam toward the circuit board (200), thereby transforming the defective portion (2121) of the defective circuit (210) into a sintered portion (212); and directing a laser beam from the second laser member (114) of the dual laser repair module (110) with an energy and/or with an angle of divergence different from that of the laser beam emitted by the first laser member (112) toward the sintered portion (212) to carry out deflashing thereof, causing sintered sides (211) of the sintered portion (212) to be flush with two conducting sides (213) of the two conducting portions (214).

## Description

### BACKGROUND OF THE INVENTION

### (a) Field of the Invention

The present disclosure relates to a dual laser repair device 100, and an operating method for a dual laser repair device 100, and more particularly to a dual laser repair device 100 and operating method thereof for sintering and deflashing circuits of a circuit board 200 with open circuit defects and short circuit defects.

### (b) Description of the Prior Art

In general, a laser repair device is used for repairing circuits of circuit boards with short circuit defects and open circuit defects. For example, a laser repair device uses a laser head to emit a laser beam toward the defects of circuits. However, because of the highly concentrated energy of the laser beam or the angle of divergence of the laser beam is too large during the process of repairing the defective circuit, the repaired circuit is prone to easily coming in contact with circuits adjacent thereto, forming a short circuit or causing other defects.

### SUMMARY OF THE INVENTION

The technical aspect of this disclosure lies in a dual laser repair device that enables preventing a repaired circuit from easily contacting other circuits adjacent thereto, thereby avoiding forming a short circuit.

According to an embodiment mode of the present disclosure, a dual laser repair is provided that is used to carry out repairs on a defective circuit of a circuit board, wherein the defective circuit is provided with two conducting portions and has a defective portion located therebetween. The dual laser repair device comprises a dual laser repair module, which comprises a first laser member and a second laser member, wherein the configuration of the first laser member and the second laser member enables separate emission of different energies and/or emitting laser beams with different angles of divergence that are directed toward the circuit board. The first laser member is used to transform the defective portion of the circuit into a sintered portion, after which the second laser member is used to carry out deflashing of the sintered portion, causing sintered sides of the sintered portion to be flush with two conducting sides of the two conducting portions.

In the embodiment mode of the present disclosure, the above operating method is carried out in a first direction, with the first laser member parallel to the second laser member; moreover, the energy of the laser beam emitted by the first laser member is greater than the energy of the laser beam emitted by the second laser member, and/or the angle of divergence of the laser beam emitted by the first laser member is greater than the angle of divergence of the laser beam emitted by the second laser member.

In the embodiment mode of the present disclosure, the above-described dual laser repair device further comprises a first displacement module, a second displacement module, and a third displacement module, wherein the first displacement module is connected to the dual laser repair module, and is used to displace the dual laser repair module in the first direction. The second displacement module is connected to the first displacement module, and is used to displace the first displacement module in a second direction. The third displacement module is provided with a loading platform, which is used to load-support a circuit board thereon. The third displacement module is used to displace the loading platform in a third direction, and each of the first direction, the second direction, and the third direction is perpendicular to the other two directions.

In the embodiment mode of the present disclosure, the above-described dual laser repair module is provided with a detector lens, which is positioned at the side of the second laser member away from the first laser member. In the second direction, the second laser member is positioned between the first laser member and the detector lens.

In the embodiment mode of the present disclosure, the above-described detector lens is orientated toward the circuit board, and is used to detect the current position of the circuit board, and produces a drive signal according to the current position, wherein the drive signal is used to drive movement of the first displacement module, the second displacement module, and the third displacement module, thereby enabling positioning the dual laser repair module and the circuit board at a specific position.

In the embodiment mode of the present disclosure, the above-described dual laser repair device further comprises measuring modules, which are correspondingly mounted on two sides of the third displacement module. When the third displacement module drives and moves the loading platform through the measuring modules, the measuring modules are used to measure a thickness of the circuit in the circuit board.

In the embodiment mode of the present disclosure, the aforementioned two conducting portions are two metal conducting wires or two polysilicon fuses, and the defective portion of the circuit is a short circuit defect. The first laser member is used to sinter the defective portion, causing a portion of the defective portion to diffuse outward, exposing a portion of the substrate of the circuit board, and causing the defective portion to transform into a sintered portion. A width of each of the two conducting portions is less than a width of the portion of the substrate exposed by the sintered portion.

In the embodiment mode of the present disclosure, the aforementioned two conducting portions are two metal conducting wires or two polysilicon fuses, and the first laser member is used to sinter the two corresponding sides of the two conducting portions and diffusely cover the defective portion, thereby transforming the defective portion into a sintered portion, and affording electrical conduction with the two conducting portions.

In an embodiment mode of the present disclosure, the aforementioned two conducting portions are two metal conducting wires or two polysilicon fuses, and the dual laser repair module is provided with an inkjet head, which is used to spray a conductive resin on the defective portion of the circuit, causing the conductive resin to partially cover the two conducting portions, and the first laser member is used to sinter the conductive resin positioned on the circuit, thereby transforming the defective portion into a sintered portion.

Another technical aspect of the present disclosure lies in the operating method of the dual laser repair device.

According to an embodiment mode of the present disclosure, the operating method for the dual laser repair device is provided herein, wherein the operating method of the dual laser repair device is used to carry out repairs on a defective circuit of a circuit board. The defective circuit has two conducting portions and a defective portion located between the two conducting portions. The operating method comprises: using the first laser member of the dual laser repair module to emit a laser beam toward the circuit board, transforming the defective portion of the defective circuit into a sintered portion; and directing a laser beam from the second laser member of the dual laser repair module with an energy and/or with an angle of divergence different from that of the laser beam emitted by the first laser member toward the sintered portion to carry out deflashing thereof, causing sintered sides of the sintered portion to be flush with two conducting sides of the two conducting portions.

In the embodiment mode of the present disclosure, the above-described operating method further comprises:driving and displacing the first displacement module, the second displacement module, and the third displacement module along the first direction, the second direction, and the third direction, respectively, thereby displacing the dual laser repair module connected to the first displacement module and the circuit board on the loading platform of the third displacement module to a specific position, wherein each of the first direction, the second direction, and the third direction is perpendicular to the other two directions.

In the embodiment mode of the present disclosure, the above-described operating method further comprises: using the detector lens of the dual laser repair module to detect the current position of the circuit board and produce a drive signal according thereto, wherein the drive signal is used to activate displacement of the first displacement module, the second displacement module, and the third displacement module, thereby enabling positioning the dual laser repair module and the circuit board at a specific position.

In the embodiment mode of the present disclosure, the above-described operating method further comprises: displacing the loading platform on the third displacement module, enabling the loading platform to measure a thickness of the circuit in the circuit board using the measuring modules mounted on two sides of the third displacement module.

In the embodiment mode of the present disclosure, the above-described operating method further comprises: removing a portion of the circuit, causing the circuit to have a defective portion, wherein the two conducting portions are two metal conducting wires or two polysilicon fuses; using the inkjet head of the dual laser repair module to spray a conductive resin on the defective portion of the circuit, causing the conductive resin to partially cover the two conducting portions; and using the first laser member to sinter the conductive resin located on the circuit, thereby transforming the defective portion into a sintered portion.

In the embodiment mode of the present disclosure, wherein the above-described first laser member is used to transform the defective portion into a sintered portion, the operating method further comprises using the first laser member to sinter the two corresponding sides of the two conducting portions to diffusely cover the defective portion, thereby transforming the defective portion into a sintered portion and affording electrical conduction with the two conducting portions, wherein the two conducting portions are two metal conducting wires or two polysilicon fuses.

In the embodiment mode of the present disclosure, transforming the aforementioned defective portion into a sintered portion, the operating method further comprises using the first laser member to sinter the defective portion, causing a portion of the defective portion to diffuse outward, exposing a portion of the substrate of the circuit board, and transforming the defective portion into a sintered portion, wherein the defect of the circuit is a short circuit defect, and a width of each of the two conducting portions is less than a width of the portion of the substrate exposed by the sintered portion.

In the above-described embodiment modes of the present disclosure, the dual laser repair device is used to carry out repairs on a defective circuit of a circuit board, wherein the configuration of the first laser member and the second laser member enables the two laser beams emitted therefrom to have different energies and/or the two laser beams are emitted with different angles of divergence that are directed toward the circuit board. In addition, the first laser member is able to transform the defective portion of the circuit into a sintered portion, while the second laser member is used to carry out deflashing of the sintered portion, causing the sintered sides of the sintered portion to be flush with the two conducting sides of the two conducting portions. Moreover, the configuration of the first laser member and the second laser member of the dual laser repair device prevents the side surfaces of the repaired circuit from contacting with other circuits, thereby preventing short circuiting.

To enable a further understanding of said objectives, structures, characteristics, and effects, as well as the technology and methods used in the present invention and effects achieved, a brief description of the drawings is provided below followed by a detailed description of the preferred embodiments.

### BRIEF DESCRIPTION OF THE DRAWINGS

When read in conjunction with the accompanying drawings, the embodiment modes of the disclosure are best understood from the following detailed description. It should be emphasized, based on standard industrial practices, the characteristics illustrated in the drawings are not drawn to scale and are used for illustrative purposes only. To clarify, in reality, the sizes of the various features can be arbitrarily increased or decreased.
Figure 1 is a three-dimensional view of an embodiment mode of a dual laser repair device according to the present disclosure.
Figure 2 is a front view of the dual laser repair module of Figure 1.
Figure 3 is a flow chart of the operating method of an embodiment mode of the dual laser repair device according to the present disclosure.
Figures 4 to 6 are cross-sectional views of a circuit of a circuit board with an open circuit defect in different states while undergoing repair according to an embodiment mode of the present disclosure.
Figures 7 and 8 are top views of the circuit of the circuit board with the open circuit defect in different states while undergoing repair according to an embodiment mode of the present disclosure.
Figures 9 and 10 are cross-sectional views of the circuit of the circuit boards with the open circuit defect in different states while undergoing repair according to an embodiment mode of the present disclosure.
Figures 11 and 12 are top views of the circuit of the circuit board with the open circuit defect in different states while undergoing repair according to an embodiment mode of the present disclosure.
Figures 13 to 15 are top views of the circuit of the circuit board with a short circuit defect in different states while undergoing repair according to the embodiment mode of the present disclosure.

### DETAILED DESCRIPTION OF THE PREFERRED EMBODIMENTS

The following content provides a detailed description of a number of different embodiment modes or examples for implementing the different characteristics thereof. Specific examples of component members and configurations are described below to simplify the specification. It is understood that such examples are only illustrative, and the present invention is not limited by such. In addition, numbers and/or letters of component members may be repeated in each of the examples described in the present disclosure. This repetition is for the purpose of simplicity and clarity, and itself does not specify a relationship between each of the embodiment modes and/or configurations described.

For example, spatial relation terminology such as "below ......", "under......", "lower portion", "on top of ......", "upper portion", etc., are used herein for the purpose of ease of description, to describe a component member shown in the accompanying drawings or the relationship between a characteristic and another component member or characteristic. Apart from specifying orientations shown in the accompanying drawings, the spatial relation terminology is also intended to include other orientations than those shown in the accompanying drawings or different orientations of the device during operation. In other words, the device can be oriented in other ways (rotated 90 degrees or other orientations), and the spatial relative descriptors used in this specification can be interpreted accordingly.

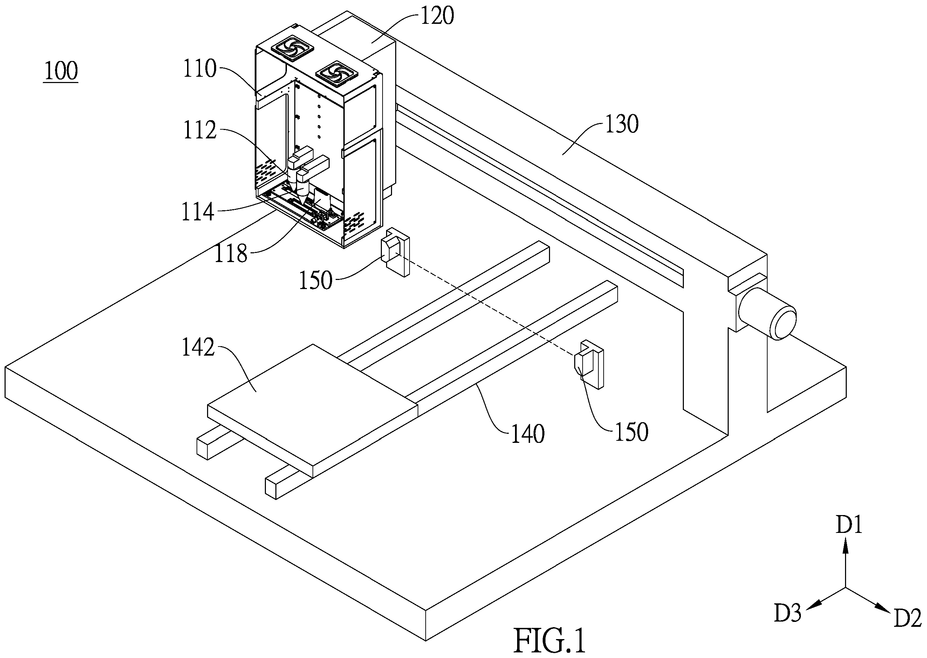

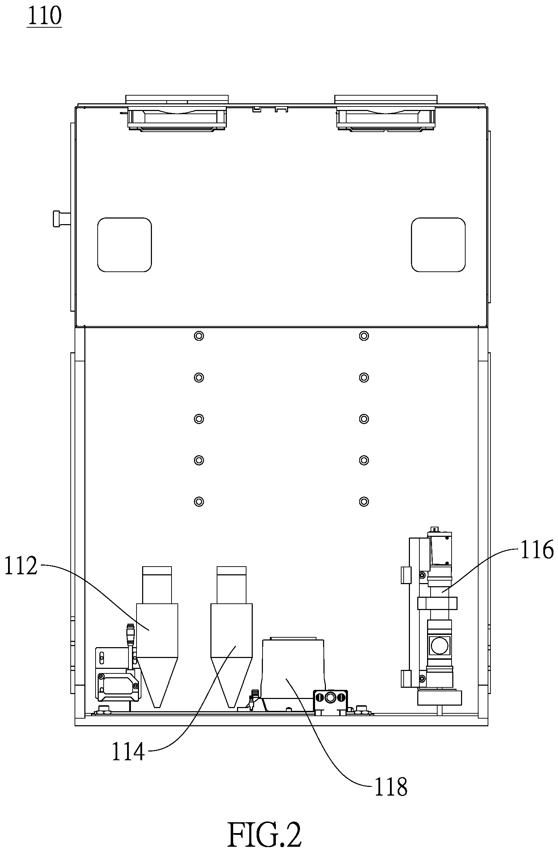

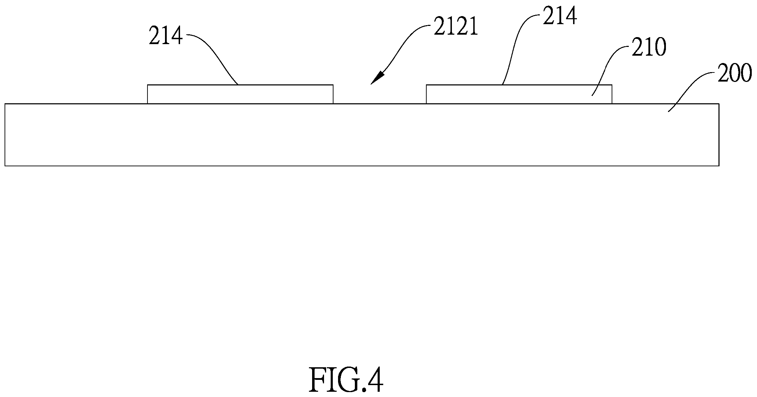

Referring to Figure 1 and Figure 2, wherein Figure 1 shows a three-dimensional view of an embodiment mode of a dual laser repair device 100 according to the present disclosure, and Figure 2 shows a front view of a dual laser repair module 110 of Figure 1, wherein the dual laser repair device 100 is used to carry out repairs on a defective circuit 210 of a circuit board 200 (Please refer to Figure 4.). For example, the defective circuit 210 has two conducting portions 214 and a defective portion 2121 located between the two conducting portions 214. The defective portion 2121 is usually a defect left during the circuit manufacturing process, such as a defect formed by uneven electroplating or other circumstances. The dual laser repair device 100 comprises the dual laser repair module 110, which further comprises a first laser member 112 and a second laser member 114. The second laser member 114 is mounted adjacent to the first laser member 112, wherein the configuration of the first laser member 112 and the second laser member 114 enables directing separate emission of different laser energies and/or two laser beams with different angles of divergence toward the circuit board 200.

In some of the embodiment modes, because the energy of the laser beam emitted by the first laser member 112 is greater than the energy of the laser beam emitted by the second laser member 114, and/or the angle of divergence of the laser beam emitted by the first laser member 112 is greater than the angle of divergence of the laser beam emitted by the second laser member 114, thus, the first laser member 112 and the second laser member 114 can be applied in different use procedures during the process of circuit repair. For example, the laser beam emitted by the first laser member 112 with a greater energy and angle of divergence can be applied in a sintering processing, and the laser beam emitted by the second laser member 114 with a lower energy and angle of divergence can be applied in a circuit deflashing process. In addition, the first laser member 112 is parallel to the second laser member 114 in a first direction D1.

In some of the embodiment modes, the dual laser repair device 100 further comprises a first displacement module 120, a second displacement module 130, and a third displacement module 140, wherein the first displacement module 120 is connected to the dual laser repair module 110, and is used to displace the dual laser repair module 110 in the first direction D1. The second displacement module 130 is connected to the first displacement module 120, and is used to displace the first displacement module 120 in a second direction D2. The third displacement module 140 is provided with a loading platform 142, which is used to load-support the circuit board 200 (Please refer to Figure 4.), and is further used to displace the loading platform 142 in a third direction D3. Each of the first direction D1, the second direction D2, and the third direction D3 is perpendicular to the other two directions.

Furthermore, the dual laser repair module 110 is provided with a detector lens 116, which is positioned at the side of the second laser member 114 away from the first laser member 112. In the second direction D2, the second laser member 114 is positioned between the first laser member 112 and the detector lens 116. The detector lens 116 is orientated toward the circuit board 200 (Please refer to Figure 4.), and is used to detect the current position of the circuit board 200, and produces a drive signal according to the current position. The drive signal is used to drive movement of the first displacement module 120, the second displacement module 130, and the third displacement module 140, thereby enabling positioning the dual laser repair module 110 and the circuit board 200 at a specific position.

Please note, the above-described configuration mode of the first displacement module 120, the second displacement module 130, and the third displacement module 140 is not intended to limit this disclosure. A configuration mode enabling displacement of the dual laser repair module 110 in several directions and a configuration mode enabling displacement of the loading platform 142 in several directions could be designed according to actual needs. For example, the dual laser repair module 110 can be completely immobile, while enabling the loading platform 142 to move in three dimensions. A configuration mode could also be designed enabling the loading platform 142 to move in three dimensions and rotate in an axial direction, thus the present disclosure is not limited by any conceivable configuration mode.

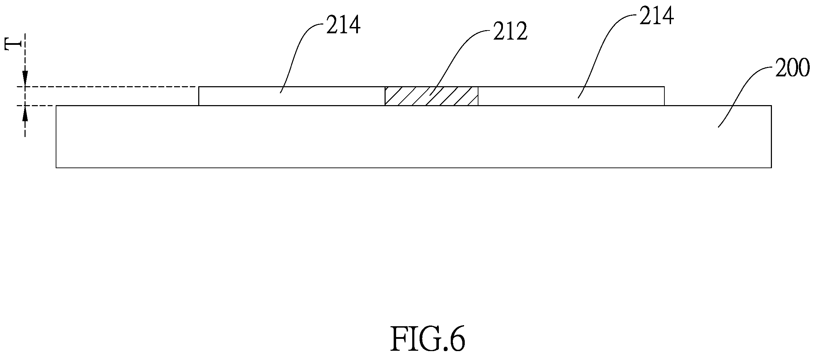

Further, the dual laser repair device 100 further comprises measuring modules 150, which are correspondingly mounted on two sides of the third displacement module 140. When the third displacement module 140 drives and moves the loading platform 142 through the measuring modules 150, the measuring modules 150 are used to measure a thickness T (Please refer to Figure 6.) of the circuit 210 in the circuit board 200.

It is hereby clarified that in the following description of the operating method of the dual laser repair device, the connection relationship between the component members, the materials, and functions already described will not be repeated.

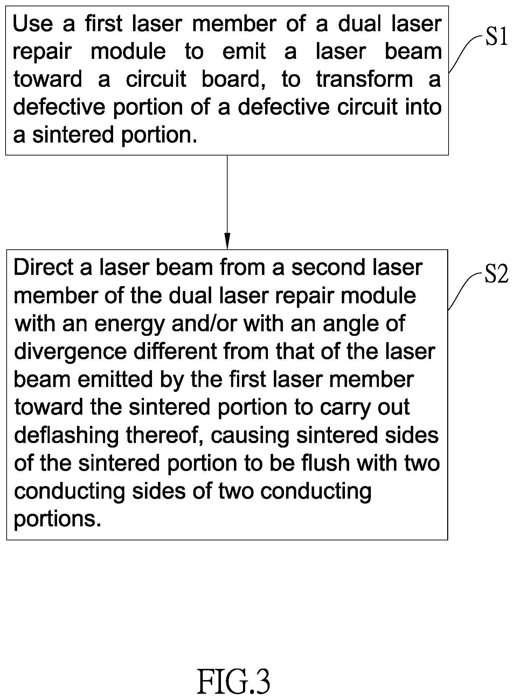

Referring to Figure 3, which shows a flow chart of the operating method of an embodiment mode of the dual laser repair device according to the present disclosure, wherein the operating method of the dual laser repair device comprises the following steps, first, in step a), using a first laser member of a dual laser repair module to emit a laser beam toward a circuit board, causing a defective portion in a defective circuit of the circuit board to transform into a sintered portion S1. Next, in step b), directing a laser beam from the second laser member of the dual laser repair module with an energy and/or with an angle of divergence different from that of the laser beam emitted by the first laser member toward the sintered portion to carry out deflashing thereof, causing sintered sides of the sintered portion to be flush with two conducting sides of the two conducting portions S2. The above-described steps are explained in detail in the following description.

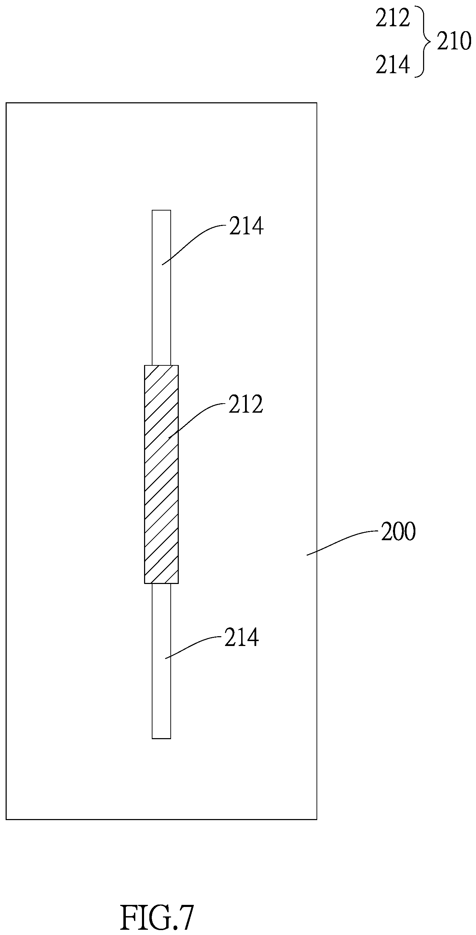

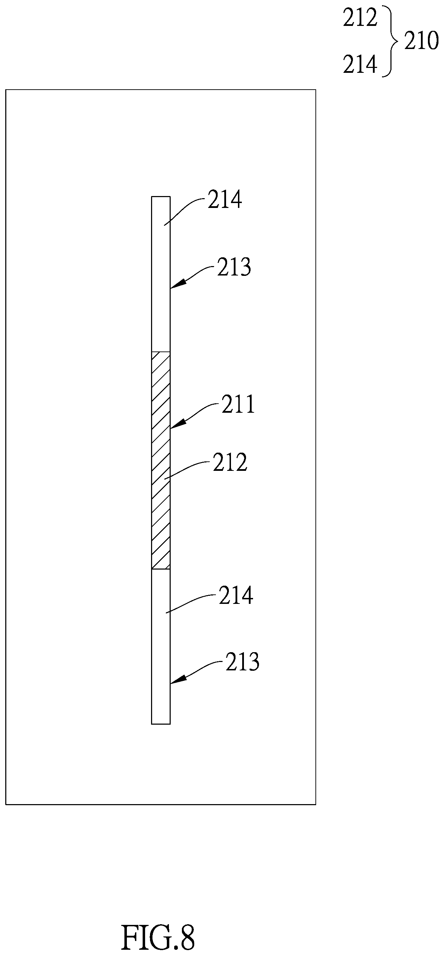

Referring to Figures 4 to 6 and Figures 7 and 8, wherein Figures 4 to 6 show cross-sectional views of the circuit 210 of the circuit board 200 with an open circuit defect in different states while undergoing repair according to an embodiment mode of the present disclosure, and Figures 7 and 8 are top views of the circuit 210 of the circuit board 200 with an open circuit defect in different states while undergoing repair according to an embodiment mode of the present disclosure. In Figures 1 to 8, the first displacement module 120, the second displacement module 130, and the third displacement module 140 are first driven and displaced along the first direction D1, the second direction D2, and the third direction D3, respectively, thereby displacing the dual laser repair module 110 connected to the first displacement module 120 and the circuit board 200 on the loading platform 142 of the third displacement module 140 to a specific position, wherein each of the first direction D1, the second direction D2, and the third direction D3 is perpendicular to the other two directions. During the displacement process of the first displacement module 120, the second displacement module 130, and the third displacement module 140, the detector lens 116 of the dual laser repair module 110 is used to detect the current position of the circuit board 200, and produces a drive signal according to the current position, wherein the drive signal is used to activate displacement of the first displacement module 120, the second displacement module 130, and the third displacement module 140, thereby enabling positioning the dual laser repair module 110 and the circuit board 200 at a specific position.

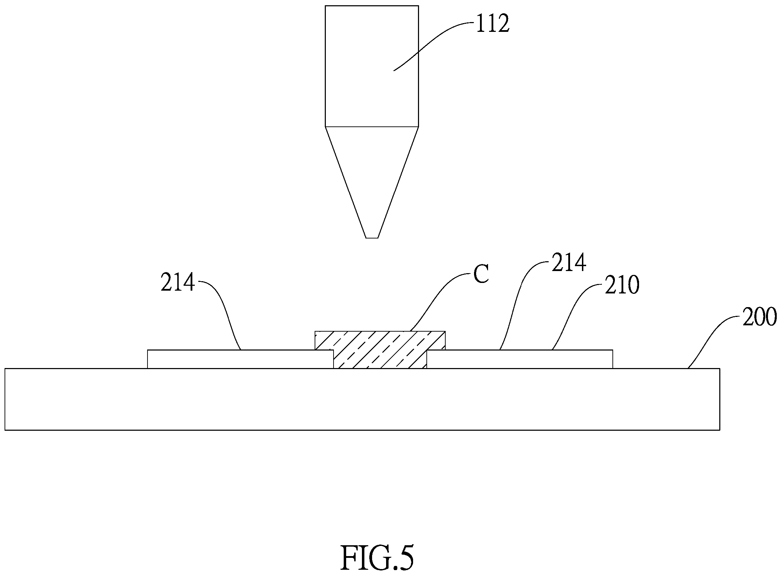

Then, after reaching the specific position, a portion of the circuit 210 is removed, causing the circuit 210 to have the defective portion 2121, wherein the two conducting portions 214 of the circuit are two metal conducting wires or two polysilicon fuses, as shown in Figure 4. Next, an inkjet head 118 of the dual laser repair module 110 is used to spray a conductive resin C on the defective portion 2121 of the circuit 210, causing the conductive resin C to partially cover the two conducting portion 214, as shown in Figure 5. After spraying the conductive resin C, the first laser member 112 is used to sinter the conductive resin C located on the circuit 210, causing the defective portion 2121 to transform into the sintered portion 212, as shown in Figure 6.

In some of the embodiment modes, the loading platform 142 is displaced on the third displacement module 140, enabling the loading platform 142 to pass through the measuring modules 150 mounted on two sides of the third displacement module 140, whereupon the measuring modules 150 measure the circuit 210 on the circuit board 200 to verify a thickness T of the sintered portion 212 and the conducting portion 214.

Then, after causing the defective portion 2121 to transform into the sintered portion 212, the second laser member 114 is used to carry out deflashing of the sintered portion 212, causing sintered sides 211 of the sintered portion 212 to be flush with two conducting sides 213 of the two conducting portions 214. Referring to Figure 8, which shows the configuration of the sintered sides 211 flush with the conducting sides 213 prevents the side surfaces of the repaired circuit 210 from contacting other circuits, thereby preventing short circuiting.

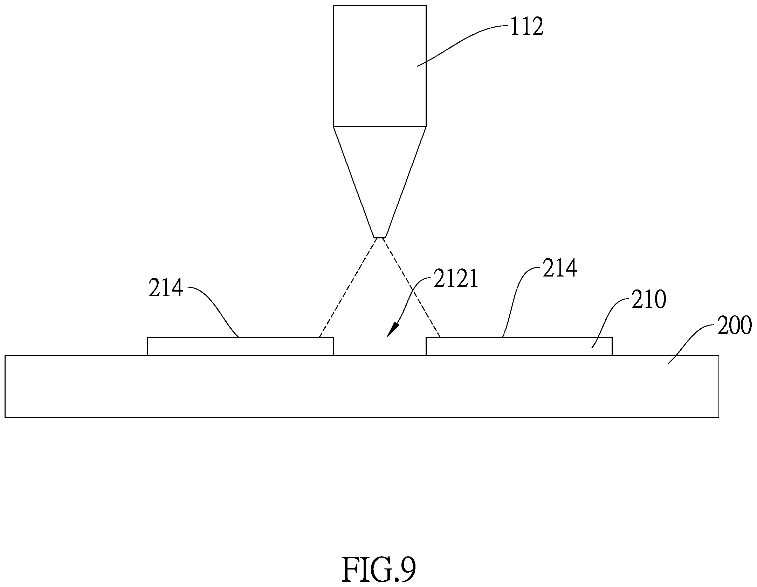

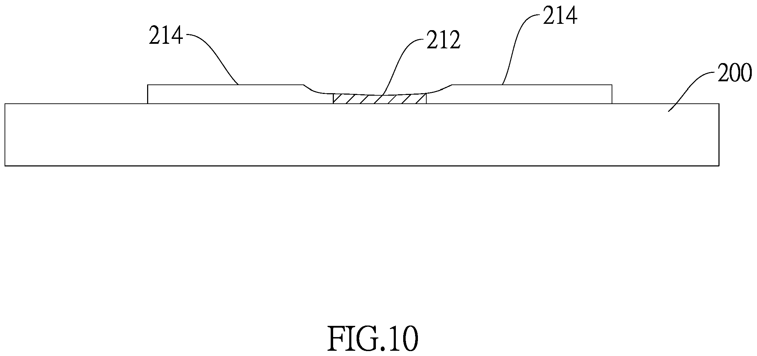

Referring to Figures 9 and 10, which show cross-sectional views of the circuit 210 of the circuit board 200 with an open circuit defect in different states while undergoing repair according to an embodiment of the present disclosure, wherein the differences between the embodiment mode shown in Figures 9 and 10 and the embodiment mode shown in Figures and 5 and 6 lie in that the conductive resin C (Please refer to Figure 5.) is not used to cover the circuit 210 in Figures 9 and 10; moreover, the first laser member 112 directly sinters the two corresponding sides of the two conducting portions 214 to diffusely cover the defective portion 2121, causing the defective portion 2121 to transform into the sintered portion 212. Accordingly, electrical conduction between the sintered portion 212 and the two conducting portions 214 is achieved, wherein the two conducting portions 214 are two metal conducting wires or two polysilicon fuses, or other conductive material.

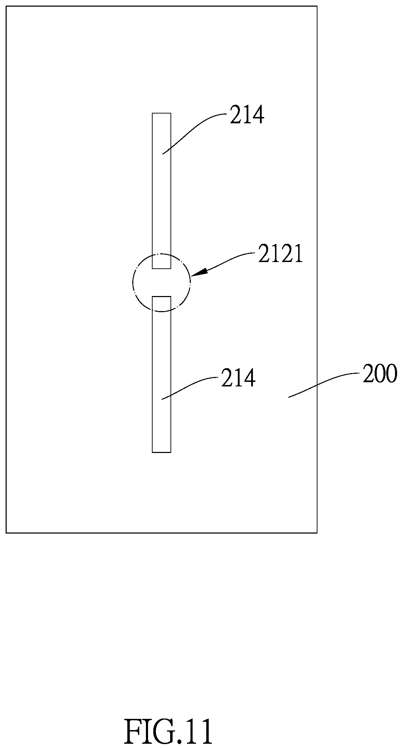

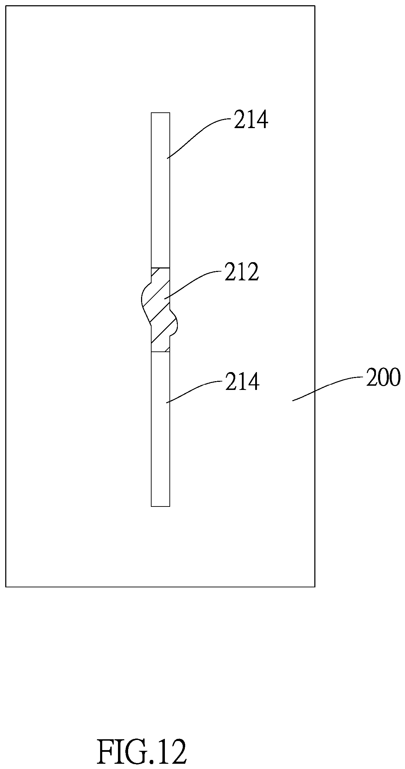

Referring to Figure 11 and Figure 12, which show top views of the circuit 210 of the circuit board 200 with an open circuit defect in different states while undergoing repair according to an embodiment mode of the present disclosure, wherein the conductive resin C (Please refer to Figure 5.) is not covering the circuit 210, and the first laser member 112 is directly sintering the two corresponding sides of the two conducting portions 214 to diffusely cover the defective portion 2121, thereby causing the defective portion 2121 to transform into the sintered portion 212, and affording electrical conduction with the two conducting portions 214 (Please refer to Figure 1.). Returning to Figure 7 and Figure 8, after causing the defective portion 2121 to transform into the sintered portion 212, the second laser member 114 is used to carry out deflashing of the sintered portion 212, to cause the sintered sides 211 of the sintered portion 212 to be flush with the two conducting sides 213 of the two conducting portions 214. The configuration of the sintered sides 211 flush with the conductive sides 213 prevents the side surfaces of the repaired circuit 210 from contacting other circuits, thereby preventing short circuiting.

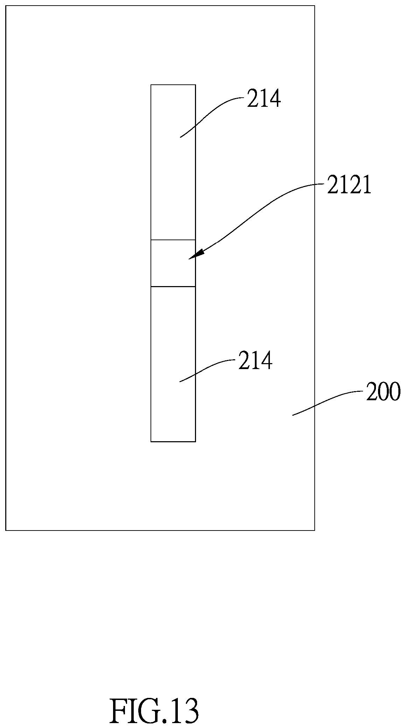

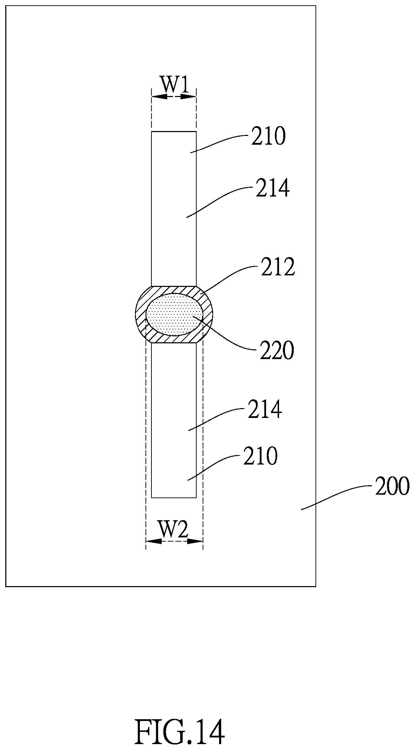

Referring to Figures 13 to 15, which show top views of the circuit 210 of the circuit board 200 with short circuit defects in different states while undergoing repair according to an embodiment of the present disclosure, and in conjunction with Figure 1, two circuits 210 are provided in the embodiment mode of the present disclosure, and the defect between the two circuits 210 is a short circuit defect. First, the first laser member 112 is used to sinter the defective portion 2121, causing a portion of the defective portion 2121 to diffuse outward and expose a portion of a substrate 220 of the circuit board 200, as well as causing the defective portion 2121 to transform into the sintered portion 212. Referring to Figure 14, wherein a width W1 of each of the two conducting portions 214 is less than a width W2 of the portion of the substrate 220 exposed by the sintered portion 212.

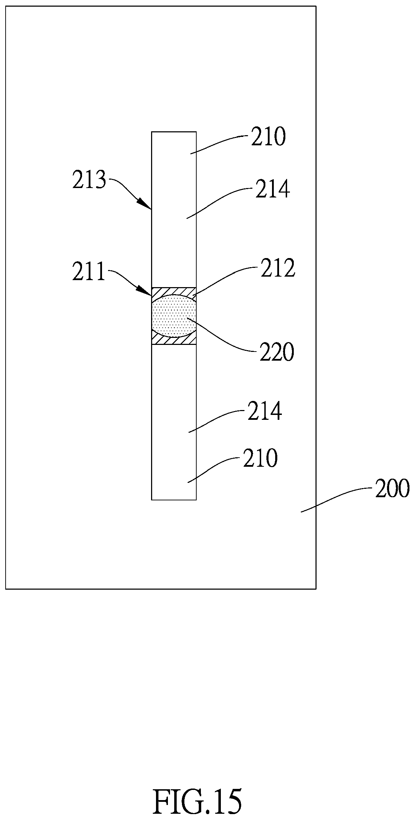

After verifying that the width W2 of the substrate 220 exposed by the sintered portion 212 is larger than the width W1 of the conducting portions 214, the second laser member 114 is used to carry out deflashing of the sintered portion 212, causing the sintered sides 211 of the sintered portion 212 to be flush with the two conducting sides 213 of the two conducting portions 214, as shown in Figure 15.

In conclusion, the dual laser repair device 100 is used to carry out repairs on a defective circuit 210 of a circuit board 200, whereby the first laser member 112 and the second laser member 114, after configuration thereof, respectively emit laser beams with different energies and/or emit laser beams with different angles of divergence directed toward the circuit board 200. Further, the first laser member112 causes the defective portion 2121 of the circuit 210 to transform into the sintered portion 212, and the second laser member 114 is used to carry out deflashing of the sintered portion 212, causing the sintered sides 211 of the sintered portion 212 to be flush with the two conducting sides 213 of the two conducting portions 214. The configuration of the first laser member 112 and the second laser member 114 of the dual laser repair device 100 prevents the side surfaces of the repaired circuit from contacting other circuits, thereby preventing short circuiting of the repaired circuit.

## Claims

1. A dual laser repair device, which is used to carry out repairs on a defective circuit (210) of a circuit board (200), wherein the defective circuit (210) has two conducting portions (214), with a defective portion (2121) being located between the two conducting portions (214); the dual laser repair device (100) comprising:
a dual laser repair module (110), further including:
a first laser member (112); and
a second laser member (114), which is configured adjacent to the first laser member (112), wherein the first laser member (112) and the second laser member (114), after configuration thereof, are used to separately emit a laser beam with different energies and/or with different angles of divergence directed toward the circuit board (200), the first laser member (112) is used to transform the defective portion (2121) of the circuit (210) into a sintered portion (212), whereafter the second laser member (114) is used to carry out deflashing of the sintered portion (212), causing sintered sides (211) of the sintered portion (212) to be flush with two conducting sides (213) of the two conducting portions (214), wherein, the first laser member (112) is parallel to the second laser member (114) in a first direction (D1), and the energy of the laser beam emitted by the first laser member (112) is greater than the energy of the laser beam emitted by the second laser member (114) and/or the angle of divergence of the laser beam emitted by the first laser member (112) is greater than the angle of divergence of the laser beam emitted by the second laser member (114);
a first displacement module (120), which is connected to the dual laser repair module (110), and is used to displace the dual laser repair module (110) in the first direction (D1);
a second displacement module (130), which is connected to the first displacement module (120), and is used to displace the first displacement module (120) in a second direction (D2); and
a third displacement module (140), which is provided with a loading platform (142), wherein the loading platform (142) is used to load-support the circuit board (200), and the third displacement module (140) is used to displace the loading platform (142) in a third direction (D3), wherein each of the first direction (D1), the second direction (D2), and the third direction (D3) is perpendicular to the other two directions;
wherein the dual laser repair module (110) is provided with a detector lens (116), which is positioned at a side of the second laser member (114) away from the first laser member (112), and the second laser member (114) is positioned between the first laser member (112) and the detector lens (116) in the second direction (D2);
wherein the detector lens (116) is orientated toward the circuit board (200), and is used to detect a current position of the circuit board (200), and produces a drive signal according to the current position, wherein the drive signal is used to drive movement of the first displacement module (120), the second displacement module (130), and the third displacement module (140), thereby enabling positioning the dual laser repair module (110) and the circuit board (200) at a specific position.

2. The dual laser repair device according to claim 1, further comprising measuring modules (150), which are correspondingly mounted on two sides of the third displacement module (140), wherein when the third displacement module (140) drives movement of the loading platform (142) through the measuring modules (150), wherein the measuring modules (150) are used to measure a thickness (T) of the circuit (210) in the circuit board (200).

3. The dual laser repair device according to claim 1, wherein the two conducting portions (214) are two metal conducting wires or two polysilicon fuses, and the defect of the circuit (210) is a short circuit defect; the first laser member (112) is used to sinter the defective portion (2121), causing a portion of the defective portion (2121) to diffuse outward, exposing a portion of a substrate (220) of the circuit board (200) and transforming the defective portion (2121) into the sintered portion (212), wherein a width (W1) of each of the two conducting portions (214) is less than a width (W2) of the portion of the substrate (220) exposed by the sintered portion (212).

4. The dual laser repair device according to claim 1, wherein the two conducting portions (214) are two metal conducting wires or two polysilicon fuses, and two corresponding sides of the two conducting portions (214) are sintered by the first laser member (112) to diffusely cover the defective portion (2121), thereby transforming the defective portion (2121) into the sintered portion (212), and affording electrical conduction with the two conducting portions (214).

5. The dual laser repair device according to claim 1, wherein the two conducting portions (214) are two metal conducting wires or two polysilicon fuses; the dual laser repair module (110) is provided with an inkjet head (118), which is used to spray a conductive resin (C) on the defective portion (2121) of the circuit (210), causing the conductive resin (C) to partially cover the two conducting portions (214), and the first laser member (112) is used to sinter the conductive resin (C) located on the circuit (210), thereby transforming the defective portion (2121) into the sintered portion (212).

6. An operating method for a dual laser repair device, which is used to carry out repairs on a defective circuit (210) of a circuit board (200), wherein the defective circuit (210) has two conducting portions (214), and a defective portion (2121) located between the two conducting portions (214); the operating method comprising steps of:
a) driving and displacing a first displacement module (120), a second displacement module (130), and a third displacement module (140) along a first direction (D1), a second direction (D2), and a third direction (D3), respectively, thereby displacing a dual laser repair module (110) connected to the first displacement module (120) and the circuit board (200) on a loading platform (142) of the third displacement module (140) to a specific position; wherein each of the first direction (D1), the second direction (D2), and the third direction (D3) is perpendicular to the other two directions; a detector lens (116) of the dual laser repair module (110) detects the current position of the circuit of the circuit board (200), and produces a drive signal according to the current position, wherein the drive signal is used to drive movement of the first displacement module (120), the second displacement module (130), and the third displacement module (140), thereby enabling positioning the dual laser repair module (110) and the circuit board (200) at a specific position;
b) using a first laser member (112) of the dual laser repair module (110) to emit a laser beam toward the circuit board (200), causing the defective portion (2121) in the defective circuit (210) to transform into a sintered portion (212), and
c) directing a laser beam from the second laser member (114) of the dual laser repair module (110) with an energy and/or with an angle of divergence different from that of the laser beam emitted by the first laser member (112) toward the sintered portion (212) to carry out deflashing thereof, causing sintered sides (211) of the sintered portion (212) to be flush with two conducting sides (213) of the two conducting portions (214).

7. The operating method for a dual laser repair device according to claim 6, further comprising:
moving a loading platform (142) on the third displacement module (140), thereby enabling the loading platform (142) to pass through measuring modules (150) mounted on two sides of the third displacement module (140); and
using the measuring modules (150) to measure a thickness (T) of the circuit (210) in the circuit board (200).

8. The operating method for a dual laser repair device according to claim 6, wherein transforming a defective portion (2121) into a sintered portion (212) further comprising:
removing a portion of the circuit (210), causing the circuit (210) to have the defective portion (2121), wherein the two conducting portions (214) are two metal conducting wires or two polysilicon fuses;
using an inkjet head (118) of the dual laser repair module (110) to spray a conductive resin (C) on the defective portion (2121) of the circuit (210), wherein the conductive resin (C) partially covers the two conducting portions (214); and
using the first laser member (112) to sinter the conductive resin (C) located on the circuit (210), thereby transforming the defective portion (2121) into the sintered portion (212).

9. The operating method for a dual laser repair device according to claim 6, wherein using the first laser member (112) to transform the defective portion (2121) into the sintered portion (212) further comprising:
using the first laser member (112) to sinter the two corresponding sides of the two conducting portions (214) to diffusely cover the defective portion (2121), thereby transforming the defective portion (2121) into the sintered portion (212), and affording electrical conduction with the two conducting portions (214), wherein the two conducting portions (214) are two metal conducting wires or two polysilicon fuses.

10. The operating method for a dual laser repair device according to claim 6, wherein transforming the defective portion (2121) into the sintered portion (212) further comprising:
using the first laser member (112) to sinter the defective portion (2121), causing a portion of the defective portion (2121) to diffuse outward, exposing a portion of a substrate (220) of the circuit board (200), and transforming the defective portion (2121) into the sintered portion (212), wherein the defect of the circuit (210) is a short circuit defect, and a width (W1) of each of the two conducting portions (214) is less than a width (W2) of the portion of the substrate (220) exposed by the sintered portion (212).
